# FASCICULE DE BREVET EUROPEEN

(11) **EP 3 156 855 B1**
(45) Date de publication et mention de la délivrance du brevet: **30.08.2017**
(21) Numéro de dépôt: 16178619.9
(22) Date de dépôt: 08.07.2016
(51) Int. Cl.: G04G 21/04, G04B 37/00

(54) **MONTRE-BRACELET MECANIQUE A LAQUELLE EST ASSOCIEE UNE FONCTION ELECTRONIQUE**
MECHANISCHES ARMBANDUHR, DIE MIT EINER ELEKTRONISCHEN FUNKTION ASSOZIERT IST
MECHANICAL WRISTWATCH WITH AN ELECTRONIC FUNCTION ASSOCIATED THERETO

(30) Priorité: 13.10.2015 EP 15189552
(43) Date de publication de la demande: 19.04.2017
(73) Titulaire: The Swatch Group Research and Development Ltd., 2074 Marin (CH)
(72) Inventeur: Martin, Jean-Claude, 2037 Montmollin (CH); Born, Jean-Jacques, 1110 Morges (CH); Conus, Thierry, 2543 Lengnau (CH); Eggen, Jean-Claude, 2552 Orpund (CH); Fleury, Emmanuel, 2740 Moutier (CH); Willemin, Michel, 2515 Prêles (CH)
(74) Mandataire: Supper, Marc

(56) Documents cités:
- CN-U- 203 812 002
- David Szondy: "Kairos TBand turns almost any watch into a smartwatch", , 24 novembre 2014 (2014-11-24), pages 1-3, XP055262033, Extrait de l'Internet: URL:http://www.gizmag.com/kairos-tband/348 11/ [extrait le 2016-04-01]

## Description

### Domaine technique de l'invention

La présente invention concerne une boîte de montre renfermant un mouvement d'horlogerie mécanique et un bracelet de montre associé à la boîte de montre de manière amovible, le bracelet de montre renfermant un dispositif électronique permettant de réaliser une fonction électronique qui vient compléter ou améliorer la ou les fonction(s) mécanique(s) réalisée(s) par le mouvement d'horlogerie mécanique logé dans la boîte de montre.

### Arrière-plan technologique de l'invention

On connaît l'attachement qu'éprouvent les utilisateurs à l'égard de leurs montres mécaniques. En effet, les mouvements d'horlogerie mécaniques sont synonymes d'un haut niveau de savoir-faire notamment en termes de miniaturisation, de précision dans l'exécution des composants, de décoration, de fiabilité de fonctionnement dans des conditions parfois extrêmes et de choix des complications horlogères proposées, valeurs que l'on retrouve moins dans le domaine des montres électroniques. Cependant, il est des fonctions, par exemple l'éclairage, offertes par les montres électroniques qui ne sont pas disponibles dans des montres purement mécaniques. C'est pourquoi une tendance actuelle forte vise à associer aux montres purement mécaniques une ou plusieurs fonction(s) électronique(s) additionnelle(s), sans néanmoins devoir aucunement modifier le mouvement d'horlogerie mécanique.

Pour atteindre cet objectif, il a déjà été proposé d'intégrer dans le bracelet des montres mécaniques des dispositifs électroniques permettant d'exécuter des fonctions électroniques additionnelles qui vont s'ajouter aux fonctions réalisées par le mouvement d'horlogerie mécanique de la montre-bracelet. A titre d'exemple, on peut citer le bracelet E-strap® commercialisé par la société Montblanc. De la sorte, l'utilisateur conserve inchangée sa montre mécanique et la valeur émotionnelle qui se rattache à une telle montre, tout en pouvant bénéficier de fonctions supplémentaires que seuls des dispositifs électroniques peuvent offrir.

On comprend de ce qui précède que le but des bracelets de montre du type décrit ci-dessus dans lesquels sont intégrés des dispositifs électroniques est d'offrir au moins une fonction électronique supplémentaire qui vient s'ajouter aux fonctions réalisées par le mouvement d'horlogerie mécanique de la montre. Autrement dit, l'exécution par le mouvement d'horlogerie mécanique renfermé dans la boîte de montre d'une fonction mécanique est totalement indépendante de l'exécution par le dispositif électronique logé dans l'épaisseur du bracelet ou dans la boucle de fermeture du bracelet d'une fonction électronique et réciproquement, si bien qu'il est tout à fait envisageable d'associer un bracelet donné à des boîtes de montres pouvant être de marques différentes.

L'article intitulé : « David Szondy : "Kairos TBand turns almost any watch into a smartwatch", pages 1-3, publié le 24 novembre 2014 et enregistré sous le numéro XP055262033 dans les bases de données de l'OEB destinées à la recherche divulgue un bracelet intelligent disponible sur le marché sous le nom TBand et produit par l'entreprise Kairos. Ce bracelet peut être attaché à n'importe quelle montre mécanique, y compris une montre réveil. Cependant, l'exécution d'une fonction électronique par le bracelet n'est pas conditionnée par l'exécution d'une fonction mécanique par la montre mécanique.

Par contre, à la connaissance de la Demanderesse, il semble qu'il n'existe actuellement pas sur le marché de bracelet de montre dans lequel est intégré un dispositif électronique dont l'exécution de la fonction pour laquelle il est prévu va dépendre de l'exécution correspondante d'une fonction assurée par le mouvement d'horlogerie mécanique.

### Résumé de l'invention

La présente invention a pour but d'associer à une montre-bracelet mécanique agencée pour exécuter au moins une première fonction mécanique un dispositif électronique agencé pour exécuter au moins une seconde fonction électronique, l'exécution par le dispositif électronique de la seconde fonction électronique étant conditionnée par l'exécution par le mouvement d'horlogerie de la première fonction mécanique.

A cet effet, la présente invention concerne une montre-bracelet comprenant une boîte de montre dans laquelle est logé un mouvement d'horlogerie mécanique comprenant un dispositif mécanique d'exécution d'au moins une première fonction mécanique, la boîte de montre étant associée à un bracelet de montre dans lequel est logé un dispositif électronique agencé pour exécuter au moins une seconde fonction électronique, l'exécution de la seconde fonction électronique étant conditionnée par l'exécution de la première fonction mécanique.

Selon un mode préféré de réalisation de l'invention, le dispositif mécanique d'exécution de la première fonction mécanique est un dispositif mécanique de sonnerie agencé pour produire un premier signal d'alarme acoustique, et le dispositif électronique logé dans le bracelet est agencé pour produire un second signal d'alarme acoustique et/ou une vibration mécanique, le dispositif électronique étant agencé pour produire le second signal d'alarme acoustique au moment où le dispositif mécanique de sonnerie produit le premier signal d'alarme acoustique. Il est aussi envisageable de différer dans le temps, par une durée fixe ou pouvant être sélectionnée par l'utilisateur, l'activation du second signal d'alarme acoustique.

Grâce à ces caractéristiques, la présente invention procure une montre-bracelet mécanique comprenant un mouvement d'horlogerie mécanique doté d'un dispositif mécanique agencé pour exécuter une fonction mécanique et auquel est associé un dispositif électronique logé dans l'épaisseur du bracelet et agencé pour exécuter une fonction électronique au moment précis où le dispositif mécanique du mouvement d'horlogerie mécanique exécute la fonction mécanique. On comprend donc que, dans un tel agencement, le mouvement d'horlogerie mécanique joue le rôle d'un maître et le dispositif électronique logé dans le bracelet joue le rôle de l'esclave.

Par montre-bracelet mécanique on entend une montre-bracelet dont les fonctions horlogères et, le cas échéant, les fonctions non liées au temps sont assurées uniquement par des composants mécaniques auxquels l'énergie nécessaire à leur fonctionnement est fournie par un ou plusieurs ressorts de barillet.

Par dispositif électronique, on entend un dispositif dont les fonctions sont assurées uniquement par des composants électriques ou électroniques et auxquels l'énergie nécessaire à leur fonctionnement est fournie par une pile ou un accumulateur éventuellement rechargeable.

Dans le mode préféré de réalisation de l'invention, le dispositif mécanique d'exécution de la première fonction mécanique est un dispositif mécanique de sonnerie agencé pour produire un premier signal d'alarme acoustique, et le dispositif électronique logé dans le bracelet est agencé pour produire un second signal d'alarme acoustique et/ou une vibration mécanique. Ainsi, lorsque le dispositif mécanique de sonnerie émet son signal d'alarme acoustique, le dispositif électronique émet simultanément ou en différé son propre signal d'alarme acoustique et/ou mécanique. Le dispositif électronique logé dans le bracelet permet donc d'améliorer les performances de fonctionnement du dispositif mécanique de sonnerie, notamment en termes de puissance acoustique produite et de mélodie par sélection et combinaison de fréquences. Ceci est très avantageux car, actuellement, le niveau sonore produit par un mouvement d'horlogerie équipé d'un dispositif mécanique de sonnerie est faible, typiquement compris entre 65 et 75 dB à 40 cm de distance. Ceci est notamment dû aux contraintes dimensionnelles et de propagation du son imposées par la géométrie et le matériau dans lequel est réalisée la boîte de montre, ainsi qu'au peu d'énergie mécanique disponible, même dans le cas où le dispositif de sonnerie mécanique est alimenté par un barillet à ressort qui lui est propre. De plus, la durée du signal d'alarme acoustique n'excède habituellement pas 10 à 20 secondes, et l'on note une baisse de l'intensité du signal acoustique lorsque le ressort de barillet est presque complètement détendu.

Dans le cas où la boîte de montre comprend un fond transparent, le dispositif électronique d'exécution de la seconde fonction électronique comprend un capteur d'images, typiquement du type CMOS (de l'anglais Complementary Metal Oxide Semi-conductor), agencé dans le bracelet de façon à se trouver sous le fond transparent. Dans ce cas, il peut être également prévu d'agencer une source de lumière dans le bracelet afin d'améliorer les conditions dans lesquelles le capteur d'images effectue les prises de vues.

Le capteur d'images est agencé pour scruter, à intervalles de temps réguliers et rapprochés, l'indication fournie par le dispositif mécanique de sonnerie. Dès que le capteur d'images constate que le dispositif mécanique de sonnerie se met en marche et émet le premier signal d'alarme acoustique, il envoie un signal électrique à une unité électronique de commande qui commande la mise en marche d'un générateur électronique de son. Ainsi, le signal d'alarme acoustique produit par le dispositif mécanique de sonnerie est renforcé par le signal d'alarme électronique, ce qui permet d'augmenter la puissance acoustique et donc d'améliorer l'audibilité du signal d'alarme acoustique produit par la montre-bracelet mécanique selon l'invention. Cela peut aussi permettre d'enrichir la sonorité de l'alarme acoustique produite par le dispositif mécanique en créant un son polyphonique. Afin que le capteur d'images puisse détecter le moment où le dispositif mécanique de sonnerie se met en marche et produit le premier signal d'alarme acoustique, il est prévu que le capteur d'images scrute à intervalles de temps réguliers et rapprochés un composant du dispositif mécanique de sonnerie qui, en temps normal, est immobile et qui se met en mouvement uniquement au moment où le dispositif mécanique de sonnerie émet le premier signal acoustique. Ce composant peut être, par exemple, une ancre de sonnerie qui pivote dans un plan horizontal autour de son point d'articulation.

Dans le cas où la boîte de montre comprend un fond opaque non conducteur de l'électricité, le dispositif électronique de détection de l'indication fournie par le dispositif mécanique de sonnerie comprend un capteur capacitif, magnétique ou inductif.

Dans le cas du capteur capacitif, celui-ci comprend typiquement un oscillateur RC, un démodulateur et un étage de sortie. Le fonctionnement d'un tel capteur capacitif se fait sans contact physique avec le dispositif mécanique de sonnerie et repose sur la modification du champ électrique dans sa zone active. Le capteur capacitif, disposé sous le fond de la boîte de montre, détecte une certaine valeur de capacité qui reste fixe aussi longtemps que le dispositif mécanique de sonnerie est au repos. Au moment où le dispositif mécanique de sonnerie se met en marche et émet le premier signal d'alarme acoustique, le capteur capacitif détecte une modification de la capacité provoquée par la mise en marche du dispositif mécanique de sonnerie, ce qui entraîne une variation de la fréquence d'oscillation du circuit RC. La détection de cette variation de fréquence génère un signal électrique de sortie qui est envoyé à l'unité électronique de commande qui commande la mise en marche du générateur électronique de son.

De manière similaire, le capteur magnétique observe une modification du champ magnétique provoquée par la mise en marche du dispositif mécanique de sonnerie. A titre d'exemple non limitatif, ce capteur magnétique peut être un capteur à magnétorésistance géante par exemple commercialisé par la société américaine NVE et également connu sous sa dénomination anglo-saxonne Giant Magnetoresistive Digital Switch ou GMR. La magnétorésistance est la propriété qu'ont certains matériaux de voir leur résistance électrique varier lorsqu'ils sont soumis à un champ magnétique. Ainsi, un capteur à magnétorésistance géante est agencé pour produire à sa sortie un signal électrique de commande en fonction de la variation du champ magnétique auquel il est soumis. Le capteur NVE est un capteur très basse consommation qui fonctionne à travers des fonds transparents (saphir, plexiglass, verre) ou des fonds opaques non-magnétiques (acier inoxydable, titane, aluminium, laiton, céramique, plastique). Il peut également s'agir d'un interrupteur Reed à lames souples. A cet effet, l'un au moins des composants du dispositif mécanique de sonnerie qui commence à se mouvoir lorsque le dispositif mécanique de sonnerie se met en marche est muni d'un aimant. Ainsi, lorsque le composant bouge, l'aimant se déplace concomitamment ce qui, dans le cas de l'interrupteur Reed, provoque une aimantation des contacts souples qui s'attirent mutuellement jusqu'à venir en contact l'un avec l'autre. L'interrupteur Reed est alors fermé et il peut envoyer un signal électrique de sortie à l'unité électronique de commande qui commande la mise en marche du générateur électronique de son.

Enfin, le capteur inductif comprend conventionnellement un bobinage réalisé autour d'un circuit magnétique qui a pour rôle de canaliser le champ magnétique. Au moins un composant du dispositif mécanique de sonnerie qui commence à se mouvoir lorsque le dispositif mécanique de sonnerie se met en marche est muni d'un aimant. Ainsi, lorsque le dispositif mécanique de sonnerie se met en marche, l'aimant bouge et induit un courant électrique dans le bobinage du capteur inductif. Le capteur inductif envoie un signal électrique de sortie à l'unité électronique de commande qui commande la mise en marche du générateur électronique de son.

Que le fond de la boîte de montre soit transparent ou opaque, conducteur ou non conducteur de l'électricité, le dispositif électronique de détection de l'indication fournie par le dispositif mécanique de sonnerie peut comprendre un dispositif simplifié comprenant un microphone qui détecte uniquement l'onde acoustique produite par la mise en marche du dispositif mécanique de sonnerie et envoie un signal électrique à l'unité électronique de commande qui commande la mise en marche du générateur électronique de son.

De même, quelles que soient les propriétés du fond de la boîte de montre, il peut être envisagé d'utiliser comme capteur un accéléromètre qui va mesurer l'activité du dispositif mécanique de sonnerie et détecter le moment où celui-ci se met en marche.

Selon une caractéristique complémentaire de l'invention, le dispositif mécanique d'exécution de la première fonction mécanique logé dans la boîte de montre comprend un organe indicateur mécanique qui fournit une indication sur l'état armé ou non-armé du dispositif mécanique d'exécution de la première fonction mécanique, et le dispositif électronique comprend des premiers moyens agencés pour scruter l'indication fournie par l'organe indicateur mécanique et des seconds moyens qui sont agencés pour scruter l'instant auquel la première fonction mécanique va se déclencher.

### Brève description des figures

D'autres caractéristiques et avantages de la présente invention ressortiront plus clairement de la description détaillée qui suit d'un exemple de réalisation d'une montre-bracelet mécanique selon l'invention à laquelle est associée une fonction électronique, cet exemple étant donné à titre purement illustratif et non limitatif seulement en liaison avec le dessin annexé sur lequel :
- la figure 1 est une vue de dessus d'un exemple de réalisation d'une montre-bracelet selon l'invention comprenant une boîte de montre équipée d'un bracelet à fonction électronique ;
- la figure 2 est une vue en perspective de dessous de la montre-bracelet de la figure 1 ;
- la figure 3 est une vue en perspective d'un exemple de réalisation du dispositif mécanique de sonnerie ;
- la figure 4a est une vue en perspective du bracelet dans lequel est logé le dispositif électronique agencé pour exécuter la seconde fonction électronique ;
- la figure 4b est une vue à plus grande échelle du dispositif électronique entouré d'un cercle sur la figure 4a ;
- les figures 5, 6 et 7 illustrent schématiquement l'ensemble formé par le dispositif mécanique agencé pour produire le premier signal d'alarme acoustique et le dispositif électronique agencé pour produire le second signal d'alarme acoustique selon que le dispositif mécanique de sonnerie est au repos, en fonctionnement, puis à nouveau à l'arrêt ;
- les figures 8 et 9 sont des vues en coupe respectivement selon les lignes VIII-VIII et IX-IX des figures 5 et 6 ;
- la figure 10 est une représentation schématique partielle de la boîte de montre selon l'invention dans le cas où le fond de la montre est opaque et non conducteur de l'électricité et où le dispositif électronique agencé pour exécuter la seconde fonction électronique comprend un capteur capacitif ;
- la figure 11 est une représentation schématique partielle de la montre-bracelet dans le cas où le fond de la montre est opaque et non conducteur de l'électricité et où le dispositif électronique agencé pour exécuter la seconde fonction électronique comprend un capteur magnétique ;
- la figure 12 est une représentation schématique partielle de la montre-bracelet dans le cas où le fond de la montre est opaque et non conducteur de l'électricité et où le dispositif électronique agencé pour exécuter la seconde fonction électronique comprend un capteur inductif ;
- la figure 13 est une représentation schématique partielle de la montre-bracelet dans le cas où la boîte de montre comprend un fond opaque conducteur de l'électricité et où le dispositif électronique de détection de l'indication fournie par le dispositif mécanique de sonnerie comprend un dispositif simplifié comprenant un microphone qui détecte l'onde acoustique produite par la mise en marche du dispositif mécanique de sonnerie et envoie un signal électrique à l'unité électronique de commande qui commande la mise en marche du générateur électronique de son ;
- la figure 14a est une représentation schématique partielle de la montre-bracelet dans le cas où le dispositif mécanique de sonnerie comprend un organe indicateur mécanique qui indique l'état non-armé du dispositif mécanique de sonnerie et où le dispositif électronique comprend une source de lumière et un détecteur de lumière ;
- la figure 14b est une vue analogue à celle de la figure 14a dans le cas où l'organe indicateur mécanique indique l'état armé du dispositif mécanique de sonnerie et où la lumière émise par la source de lumière est réfléchie par la portion de surface réfléchissante de l'organe indicateur mécanique en direction du détecteur de lumière ;
- la figure 15a est une représentation schématique partielle de la montre-bracelet dans le cas où le dispositif mécanique de sonnerie comprend un organe indicateur mécanique qui indique l'état non-armé du dispositif mécanique de sonnerie et où le dispositif électronique comprend un capteur d'images dont une première fraction de la surface est utilisée pour scruter l'indication fournie par l'organe indicateur mécanique, et dont une seconde fraction de la surface est utilisée pour scruter la mise en marche du dispositif mécanique de sonnerie ;
- la figure 15b est une vue analogue à celle de la figure 15a dans le cas où l'organe indicateur mécanique s'efface et sort du champ de vision du capteur d'images lorsque le dispositif mécanique de sonnerie est armé par l'utilisateur ;
- la figure 16a est une représentation schématique partielle de la montre-bracelet l'invention dans le cas où le dispositif mécanique de sonnerie comprend un organe indicateur mécanique qui masque le dispositif mécanique de sonnerie lorsque ce dernier n'est pas armé, et
- la figure 16b est une vue analogue à celle de la figure 16a dans le cas où l'organe indicateur mécanique s'est effacé.

### Description détaillée d'un mode de réalisation de l'invention

La présente invention procède de l'idée générale inventive qui consiste à associer à une montre-bracelet mécanique conçue pour exécuter une première fonction mécanique en plus de l'affichage de l'heure courante un bracelet dans l'épaisseur duquel est logé un dispositif électronique conçu pour exécuter une seconde fonction électronique, l'exécution de la seconde fonction électronique étant conditionnée par l'exécution de la première fonction mécanique. Dans un mode de réalisation préféré mais non limitatif de la présente invention, la montre-bracelet mécanique est agencée pour émettre une première alarme acoustique à un moment prédéterminé programmé par l'utilisateur, et le dispositif électronique logé dans le bracelet est agencé pour émettre une seconde alarme acoustique et/ou une vibration mécanique au moment où la montre émet la première alarme acoustique. Il est ainsi possible d'augmenter la puissance acoustique du signal d'alarme produit par la montre-bracelet selon l'invention sans devoir apporter aucune modification au mouvement mécanique logé dans la montre. Il est également possible d'augmenter la durée du signal d'alarme et d'émettre d'autres sons que ceux produits par le mouvement mécanique, en harmonie avec ces derniers.

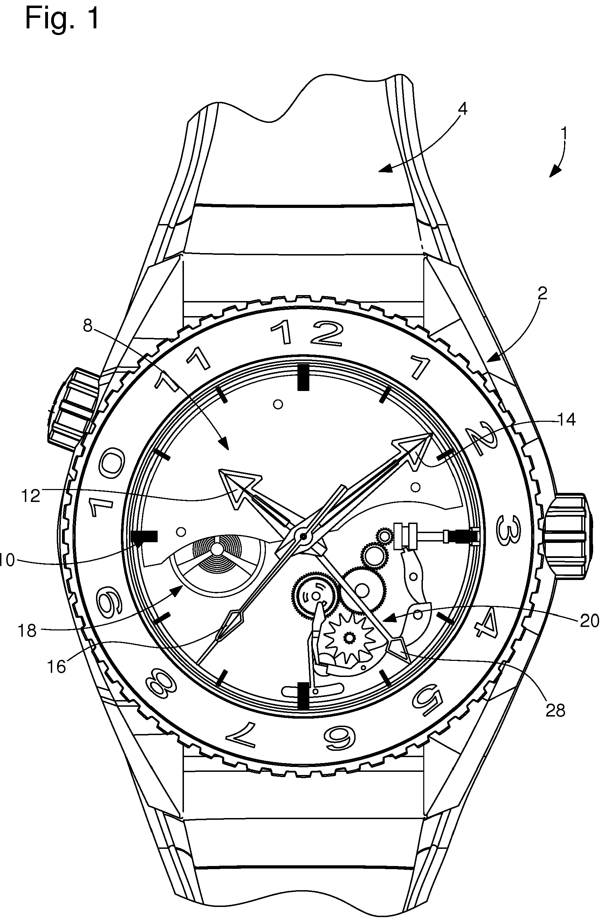

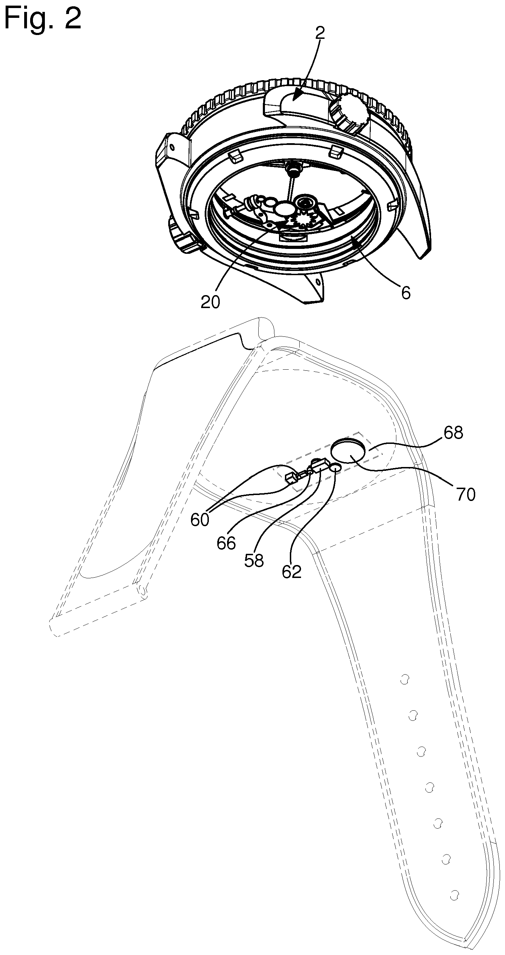

Désignée dans son ensemble par la référence numérique générale 1, la montre-bracelet selon l'invention comprend (voir figures 1 et 2) une boîte de montre 2 conçue pour être portée au poignet d'un utilisateur au moyen d'un bracelet 4. Dans le mode de réalisation préféré mais non limitatif de l'invention, la boîte de montre 2 est fermée à sa base par un fond 6 et à son sommet par une glace 8 qui recouvre un cadran 10 au-dessus duquel se déplacent des aiguilles d'heures 12, de minutes 14 et de secondes 16 pour l'affichage de l'heure courante. Dans l'exemple illustré à la figure 1, le cadran 10 est représenté en transparence. Il va néanmoins de soi que pour les besoins de la présente invention, le cadran 10 n'a nullement besoin d'être transparent et qu'il sera préférentiellement opaque.

Un mouvement d'horlogerie mécanique 18 conçu pour entraîner les aiguilles 12, 14 et 16 d'affichage de l'heure courante est logé dans la boîte de montre 2. Ce mouvement d'horlogerie mécanique 18 comprend en outre un dispositif mécanique 20 agencé pour produire au moins une première fonction mécanique, par exemple émettre un premier signal d'alarme acoustique.

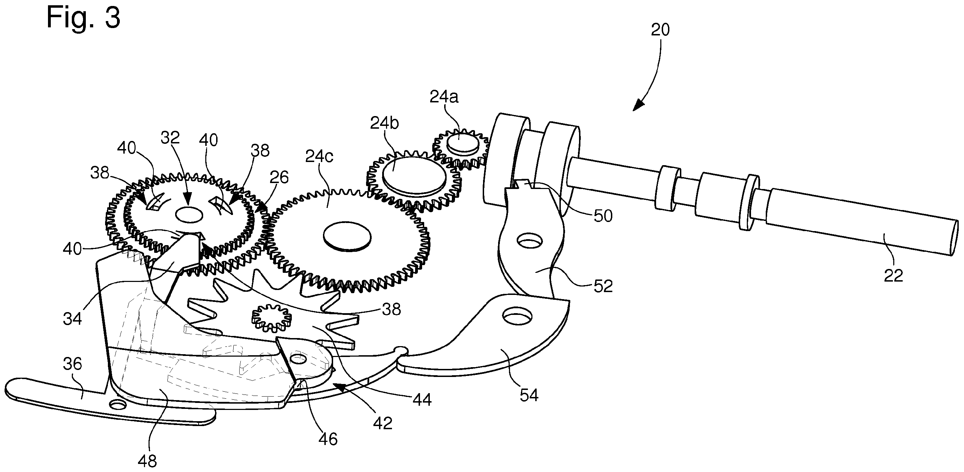

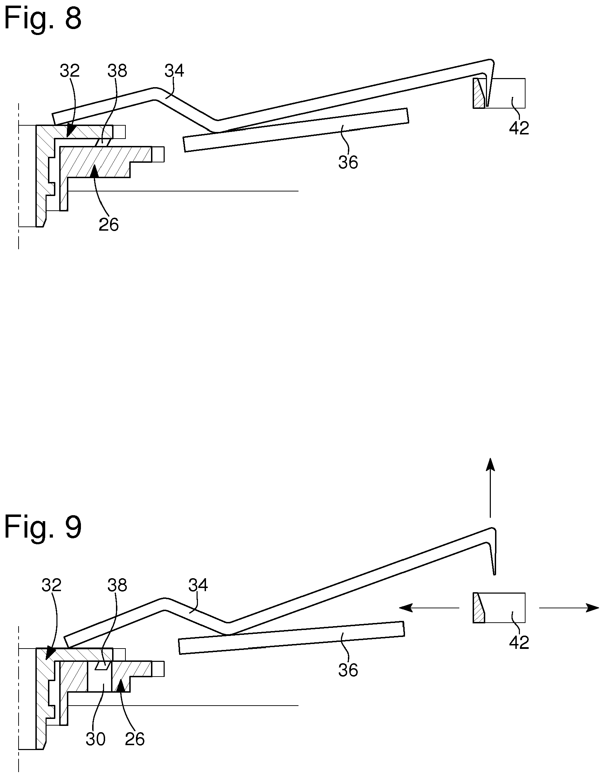

A titre d'exemple illustratif seulement (voir figure 3), le dispositif mécanique de sonnerie 20 comprend une tige de remontoir 22 qui fait tourner par l'intermédiaire d'une première, d'une deuxième et d'une troisième roue de renvoi 24a, 24b et 24c une roue de déclenchement 26. Le canon de la roue de déclenchement 26 porte, ou est lié cinématiquement, à un index 28 visible sur la figure 1 que l'on peut placer en regard de l'heure de sonnerie désirée. La planche de la roue de déclenchement 26 est percée de trois ouvertures 30 placées sur trois rayons différents (voir figure 9). Une roue des heures 32 pivote au-dessus de la roue de déclenchement 26 et est plaquée contre la roue de déclenchement 26 par un levier de déclenchement 34 armé par un ressort 36. La roue des heures 32 possède dans sa planche trois ergots 38 munis chacun d'un plan incliné 40. La roue des heures 32, entraînée par le mouvement, tourne et, à l'instant prévu pour la sonnerie, les trois ergots 38 se trouvent en face des ouvertures 30 et tombent dans ces dernières, de sorte que la roue des heures 32 vient se plaquer contre la roue de déclenchement 26. Sous l'effet de ce mouvement, le levier de déclenchement 34 bascule vers le haut et libère une ancre de sonnerie 42 qui, entraînée par une roue de sonnerie 44, se met à osciller dans un plan horizontal autour de son point de pivotement 46 (voir figure 9). La roue de sonnerie 44 qui est directement entraînée par un barillet de sonnerie (non représenté) agit à la façon d'une roue d'échappement qui entraîne l'ancre de sonnerie 42. L'ancre de sonnerie 42 porte un marteau 48 qui frappe une goupille fixée au fond de la boîte de façon à faire retentir la sonnerie. L'extrémité d'une bascule de remontoir de sonnerie 50 est en relation avec une bascule de verrou 52 qui agit sur un verrou de sonnerie 54. Le verrou de sonnerie 54 immobilise l'ancre de sonnerie 42 lorsque la tige de remontoir 22 est en position de mise à l'heure.

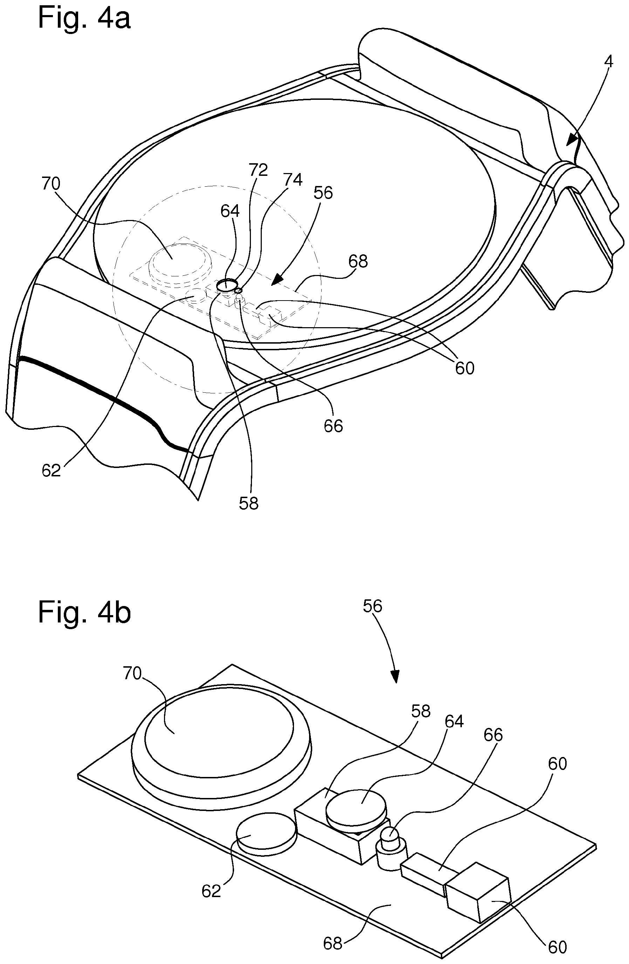

Comme représenté sur les figures 4a et 4b, un dispositif électronique 56 logé dans le bracelet 4 est agencé pour exécuter au moins une seconde fonction électronique, par exemple émettre un second signal d'alarme acoustique et/ou produire une vibration mécanique, l'exécution de la seconde fonction électronique étant conditionnée par l'exécution de la première fonction mécanique. Autrement dit, le dispositif électronique 56 va émettre le second signal d'alarme acoustique et/ou produire une vibration mécanique au moment où le dispositif mécanique de sonnerie 20 va produire le premier signal d'alarme acoustique. Le dispositif mécanique de sonnerie 20 logé dans la boîte de montre 2 est donc le maître du dispositif électronique 56 qui joue la fonction d'esclave. On notera que la fonction maître n'est pas dépendante de la fonction esclave et peut fonctionner normalement même si la fonction esclave n'est pas opérationnelle. On notera également que, selon une variante, il peut être envisagé de différer d'une durée fixe, par exemple 5 ou 10 secondes, ou choisie par l'utilisateur le moment où le dispositif électronique 56 va s'enclencher et produire le second signal acoustique.

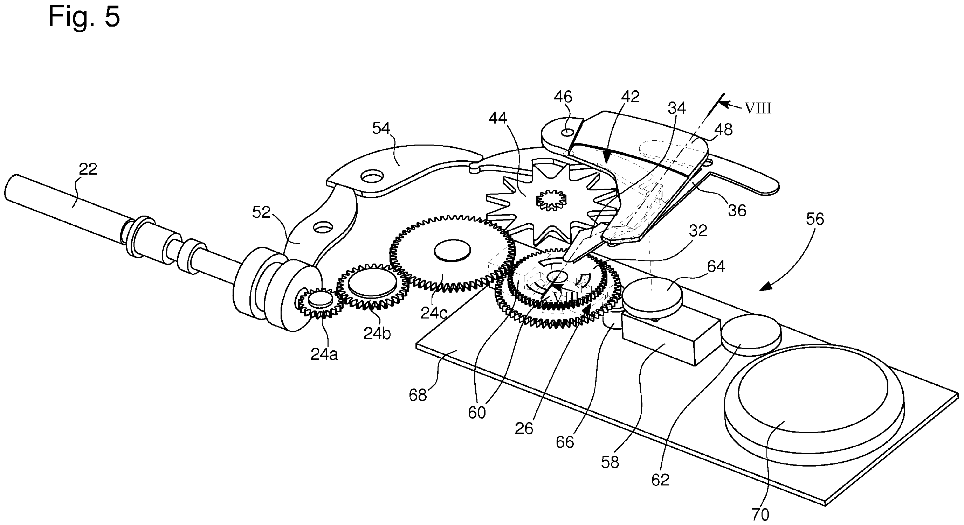

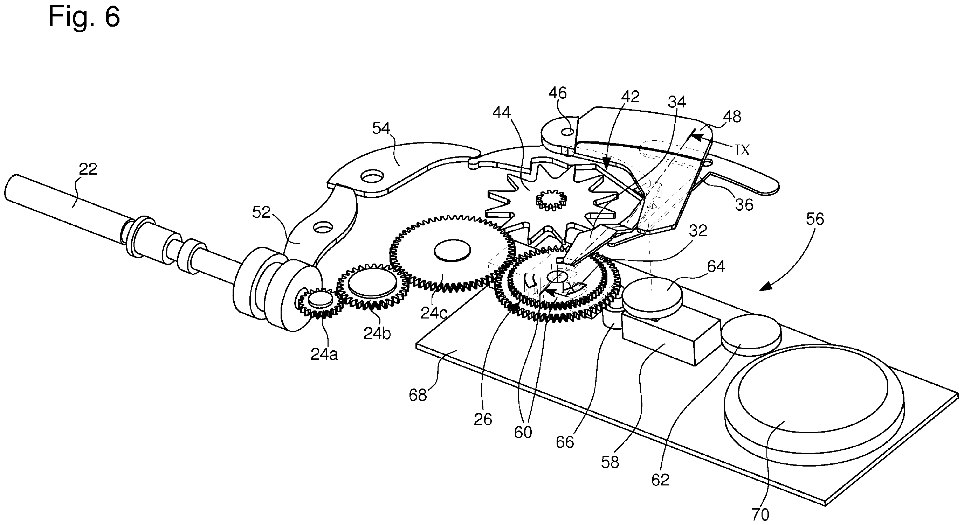

Le dispositif électronique 56 logé dans le bracelet 4 de la montre-bracelet 1 comprend quant à lui un capteur d'images 58 qui scrute à intervalles de temps réguliers et rapprochés le moment où le dispositif mécanique de sonnerie 20 va se mettre en marche. Le dispositif mécanique de sonnerie 20 est initialement à l'arrêt (figures 5 et 8). Au moment où le dispositif mécanique de sonnerie 20 se met en marche (figures 6 et 9), la roue des heures 32 se plaque contre la roue de déclenchement 26 et le levier de déclenchement 34, plaqué contre la roue des heures 32 par le ressort 36, pivote vers le haut, libérant l'ancre de sonnerie 42 qui se met à osciller dans le plan horizontal autour de son point de pivotement 46. Le marteau 48, porté par l'ancre de sonnerie 42, suit le mouvement de cette dernière et vient frapper par exemple une goupille. Le capteur d'images 58 détecte la mise en mouvement d'un mobile du dispositif mécanique de sonnerie tel que l'ancre de sonnerie 42 et envoie un signal électrique à une unité de commande 60 qui va commander la mise en marche d'un générateur électronique de son 62 de type électromécanique ou piézoélectrique. Avantageusement, le capteur d'images 58 est recouvert par une lentille de collimation 64, et une source de lumière 66 telle qu'une diode électroluminescente éclaire l'intérieur de la boîte de montre 2 à travers le fond 6 transparent. L'ensemble de ces composants électroniques est monté sur une feuille de circuit imprimé 68 logée dans l'épaisseur du bracelet 4 et est alimenté par une source de courant électrique 70. Bien-entendu, des ouvertures 72 et 74 sont ménagées au-dessus du capteur d'images 58 et de la source de lumière 66 dans la matière dont est réalisé le bracelet 4, ceci afin de permettre au capteur d'images 58 de scruter le dispositif mécanique de sonnerie 20 et à la source de lumière 66 d'éclairer la scène.

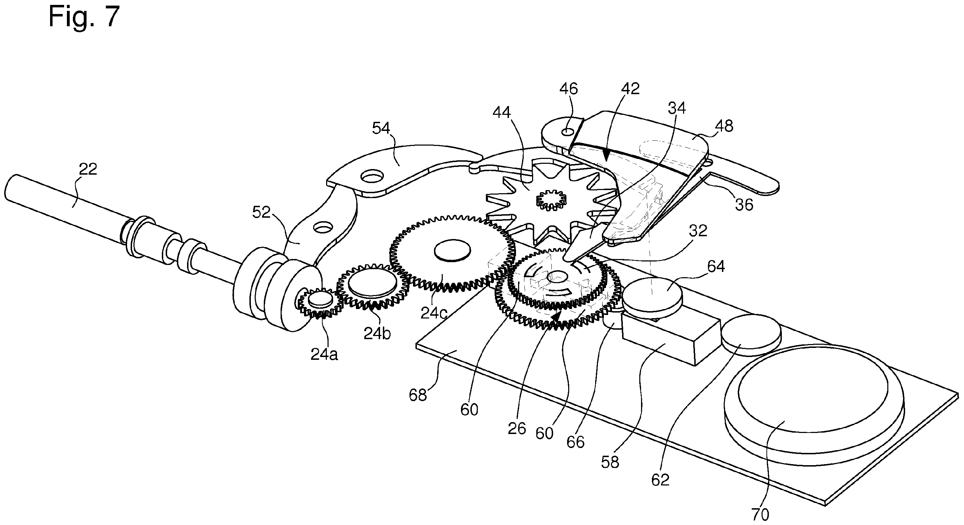

Le capteur d'images 58 est par exemple un capteur d'images commercialisé par la société STMicroelectronics sous la référence VD5376. Son épaisseur est comprise entre 180 µm et 725 µm, ses côtés mesurent respectivement 1900 µm et 1932 µm et sa surface active de 608x608 µm² est formée d'une matrice de 20x20 pixels. Un tel capteur d'images 58 est capable de détecter un changement dans les niveaux de gris d'une image qu'il scrute et donc de déceler par exemple le déplacement d'un objet tel que l'ancre de sonnerie 42. On comprendra que le capteur d'images 58 peut détecter la mise en mouvement d'un autre mobile comme la roue de sonnerie 44 ou bien le marteau 48. Un nouveau changement est observé par le capteur d'images 58 lorsque le premier signal d'alarme acoustique s'interrompt et que le mobile que scrute le capteur d'images 58 s'arrête (figure 7). L'image que voit le capteur d'images 58 devient en effet à nouveau immobile. Le capteur d'images 58 envoie alors un signal électrique à l'unité de commande 60 qui va commander l'arrêt du générateur électronique de son 62.

Selon une variante simplifiée d'exécution de l'invention, il peut être envisagé de fixer par avance la durée de la seconde alarme. Une fois démarrée suite à l'activation de la première alarme, la seconde alarme s'arrêtera de façon autonome une fois ce temps écoulé.

On remarque qu'un examen comparé des figures 5 et 6 permet de se rendre compte qu'à la figure 6, la roue des heures 32 s'est plaquée contre la roue de déclenchement 26 et qu'à la figure 7, la roue des heures 32 est à nouveau écartée de la roue de déclenchement 26.

Dans le cas où la boîte de montre 2 comprend un fond 6 opaque non conducteur de l'électricité, le dispositif électronique 56 de détection de l'indication fournie par le dispositif mécanique de sonnerie 20 comprend un capteur capacitif, magnétique ou inductif.

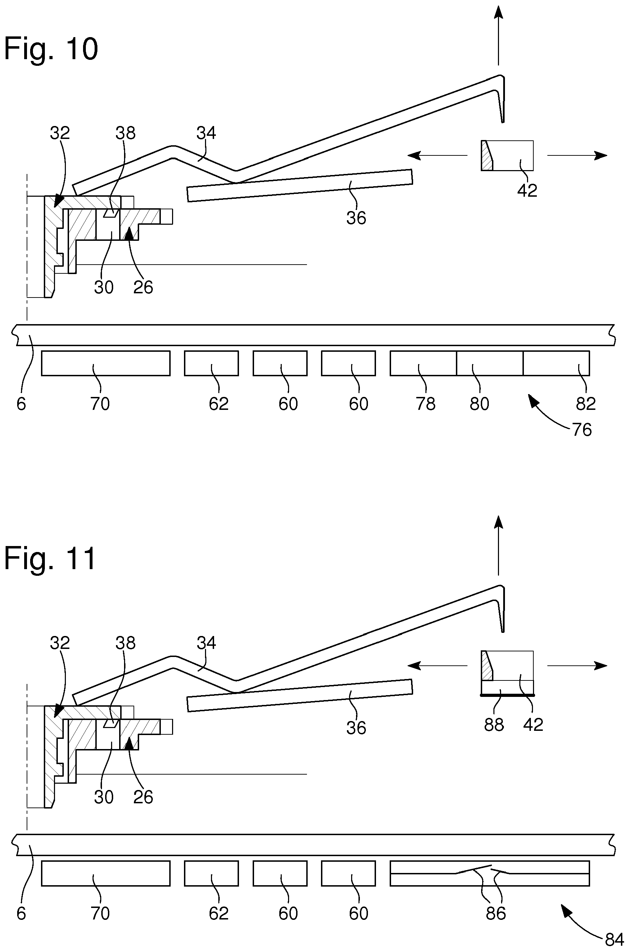

Dans le cas d'un capteur capacitif 76 (figure 10), celui-ci comprend typiquement un oscillateur RC 78, un démodulateur 80 et un étage de sortie 82. Le fonctionnement d'un tel capteur capacitif 76 se fait sans contact physique avec le dispositif mécanique de sonnerie 20 et repose sur la modification du champ électrique dans sa zone active. Le capteur capacitif 76, disposé sous le fond de la boîte de montre, détecte une certaine valeur de capacité qui reste fixe aussi longtemps que le dispositif mécanique de sonnerie 20 est au repos. Au moment où le dispositif mécanique de sonnerie 20 se met en marche et émet le premier signal d'alarme acoustique, le capteur capacitif 76 détecte une modification de la capacité provoquée par la mise en marche du dispositif mécanique de sonnerie 20, ce qui entraîne une modification de la fréquence d'oscillation du circuit RC 78. Suite à la détection de cette variation de fréquence, un signal électrique de sortie est généré et envoyé à l'unité électronique de commande 60 qui commande la mise en marche du générateur électronique de son 62. A titre d'exemple, le capteur capacitif peut être celui commercialisé par la société suisse EM-Microelectronic sous la référence EM6420. Il s'agit d'un capteur capacitif très basse consommation apte à fonctionner aussi bien avec des fonds transparents (saphir, plexiglass, verre) qu'avec des fonds opaques non métalliques (plastique, céramique). Il faut raccorder au circuit EM6420 une électrode qui sera placée dans le bracelet en face de la pièce en métal qui se mettra en mouvement lors de l'enclenchement de l'alarme.

De manière similaire (figure 11), le capteur magnétique tel qu'un capteur GMR commercialisé par la société NVE ou bien un interrupteur Reed 84 à lames souples 86 observe une modification du champ magnétique provoquée par la mise en marche du dispositif mécanique de sonnerie 20. A cet effet, l'un au moins des composants du dispositif mécanique de sonnerie 20, par exemple l'ancre de sonnerie 42, qui commence à se mouvoir lorsque le dispositif mécanique de sonnerie 20 se met en marche est muni d'un aimant 88. Ainsi, lorsque le composant bouge, l'aimant 88 se déplace concomitamment, ce qui provoque une aimantation des contacts souples 86 qui s'attirent mutuellement jusqu'à venir en contact l'un avec l'autre. L'interrupteur Reed 84 est alors fermé et il peut envoyer un signal électrique de sortie à l'unité électronique de commande 60 qui commande la mise en marche du générateur électronique de son 62.

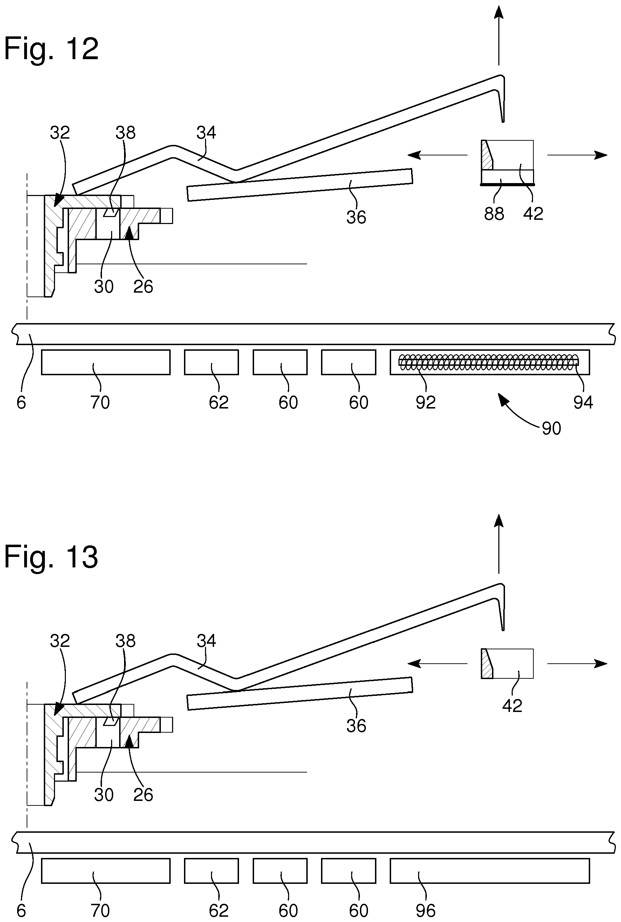

Enfin (figure 12), le capteur inductif 90 comprend conventionnellement un bobinage 92 réalisé autour d'un circuit magnétique 94 qui a pour rôle de canaliser le champ magnétique. Au moins un composant du dispositif mécanique de sonnerie 20, par exemple l'ancre de sonnerie 42, qui commence à se mouvoir lorsque le dispositif mécanique de sonnerie 20 se met en marche est muni d'un aimant 88. Ainsi, lorsque le dispositif mécanique de sonnerie 20 se met en marche, l'aimant 88 bouge et induit un courant électrique dans le bobinage 92 du capteur inductif 90. Le capteur inductif 90 envoie un signal électrique de sortie à l'unité électronique de commande 60 qui commande la mise en marche du générateur électronique de son 62.

A titre de variante, le capteur inductif peut comprendre un circuit oscillant LC dont l'inductance va varier sous l'effet du déplacement d'un composant métallique du dispositif mécanique.

Que le fond 6 de la boîte de montre 2 soit transparent ou opaque, conducteur ou non conducteur de l'électricité (figure 13), le dispositif électronique 56 de détection de l'indication fournie par le dispositif mécanique de sonnerie 20 peut comprendre un dispositif simplifié comprenant un microphone 96 qui détecte uniquement l'onde acoustique produite par la mise en marche du dispositif mécanique de sonnerie 20 et envoie un signal électrique à l'unité électronique de commande 60 qui commande la mise en marche du générateur électronique de son 62.

De même, quelles que soient les propriétés du fond 6 de la boîte de montre 2, il peut être envisagé d'utiliser comme capteur un accéléromètre qui va mesurer l'activité du dispositif mécanique de sonnerie et détecter les vibrations engendrées par le marteau 48 au moment où le dispositif mécanique de sonnerie se met en marche. Un accéléromètre bien adapté aux besoins de la présente invention est celui diffusé sous la référence ADXL362. Il s'agit d'un circuit très basse consommation qui constitue une alternative intéressante au microphone notamment du point de vue de l'étanchéité et des coûts d'intégration.

Comme vu en détail ci-dessus, le dispositif électronique 56 logé dans le bracelet 4 est agencé pour exécuter au moins une seconde fonction électronique, par exemple émettre un second signal d'alarme acoustique et/ou produire une vibration mécanique, l'exécution de la seconde fonction électronique étant conditionnée par l'exécution de la première fonction mécanique. Autrement dit, le dispositif électronique 56 va émettre le second signal d'alarme acoustique et/ou produire une vibration mécanique au moment où le dispositif mécanique de sonnerie 20 va produire le premier signal d'alarme acoustique. Le mouvement d'horlogerie mécanique 18 logé dans la boîte de montre 2 est donc le maître du dispositif électronique 56 qui joue la fonction d'esclave.

Selon une caractéristique complémentaire de l'invention, le dispositif mécanique 20 d'exécution de la première fonction mécanique logé dans la boîte de montre 2 comprend en outre un organe indicateur mécanique 98 qui fournit une indication sur l'état armé ou non-armé du dispositif mécanique 20 d'exécution de la première fonction mécanique. Ainsi, si le dispositif mécanique 20 est armé par l'utilisateur pour produire un signal d'alarme acoustique à une heure prédéterminée choisie par l'utilisateur, l'organe indicateur mécanique 98 va indiquer que le dispositif mécanique 20 est armé.

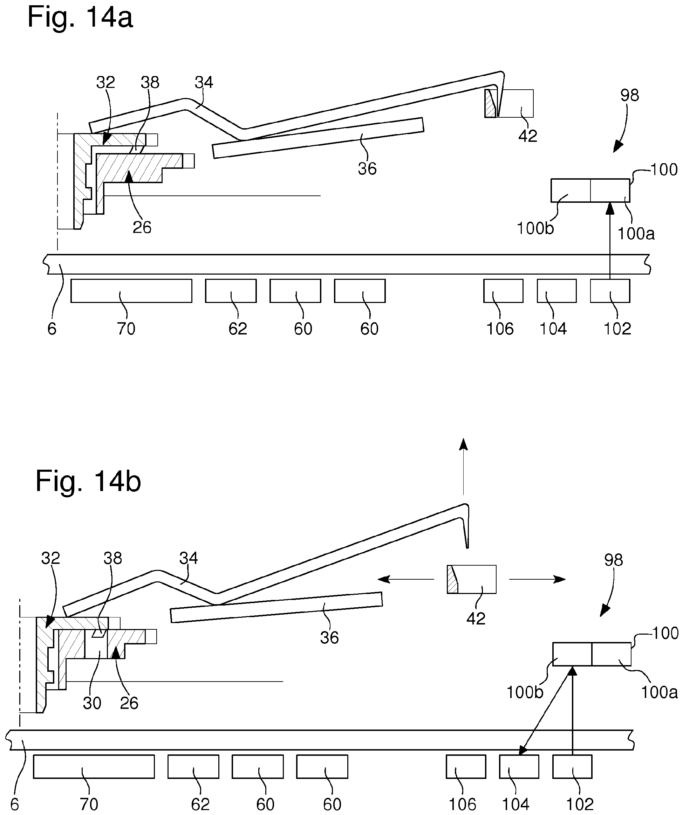

Selon un premier mode de réalisation illustré à la figure 14a, l'organe indicateur mécanique 98 comprend une pastille 100 dont une première partie de la surface 100a est absorbante et dont une seconde partie de la surface 100b est réfléchissante. Cette pastille 100 est agencée pour se déplacer entre une première et une seconde position selon que le dispositif mécanique 20 est armé ou non-armé. Quant au dispositif électronique 56, il comprend une source de lumière 102 telle qu'une diode électroluminescente et un capteur de lumière 104 tel qu'une photodiode logés dans le bracelet 4, sous la pastille 100. La lumière émise par la source de lumière 102 sera donc absorbée ou réfléchie selon qu'elle tombe sur la portion de surface 100a absorbante ou sur la portion de surface 100b réfléchissante de la pastille 100. Enfin, un capteur d'images 106 qui peut être du même type que celui décrit ci-avant ou plus simple scrute le moment où le dispositif mécanique de sonnerie 20 va se mettre en marche.

Le fonctionnement de ce dispositif est le suivant. La source de lumière 102 va, à intervalles de temps réguliers, envoyer un faisceau de lumière sur la pastille 100. Si le dispositif électronique 56 constate, en raison de l'absence de signal fourni par le capteur de lumière 104, que la lumière émise par la source de lumière 102 tombe sur la portion de surface 100a absorbante de la pastille 100 et est donc absorbée, il en conclut que le dispositif mécanique de sonnerie 20 n'est pas armé. Par conséquent, il n'est pas nécessaire que le capteur d'images 106 scrute le moment où le dispositif mécanique de sonnerie 20 va se mettre en marche, ce qui permet de réaliser des économies d'énergie. En effet, la source de lumière 102 éclaire la pastille 100 moins souvent que le capteur d'images 106 ne scrute le moment où le dispositif mécanique de sonnerie 20 va se mettre en marche. Lorsque l'utilisateur arme le dispositif mécanique de sonnerie 20 par exemple par pression sur un bouton-poussoir, la pastille 100 va se déplacer de façon que la lumière émise par la source de lumière 102 tombe sur la portion de surface 100b réfléchissante de la pastille 100. Ainsi, le dispositif électronique 56 va constater, en raison du signal fourni par le capteur de lumière 104, que la lumière émise par la source de lumière 102 tombe sur la portion de surface 100b réfléchissante de la pastille 100 et est donc réfléchie, et va conclure que le dispositif mécanique de sonnerie 20 est armé. A ce moment-là, le dispositif électronique 56 coupe l'alimentation électrique de la source de lumière 102 et commande la mise en marche du capteur d'images 106. Le capteur d'images 106 va alors scruter à intervalles de temps réguliers et rapprochés le moment où le dispositif mécanique de sonnerie 20 va se mettre en marche. Lorsque le dispositif mécanique de sonnerie 20 se met en marche, le fonctionnement du dispositif mécanique de sonnerie 20 et du dispositif électronique 56 est le même que celui décrit ci-dessus en liaison avec le premier mode de réalisation de l'invention.

Selon un second mode de réalisation non représenté, on peut envisager qu'au lieu d'avoir une portion de surface réfléchissante et une portion de surface absorbante, la pastille 100 soit munie d'une portion de surface qui réfléchit la lumière en direction du capteur de lumière 104 et une portion de surface qui réfléchit la lumière selon une direction dans laquelle le capteur de lumière 104 ne peut capter la lumière.

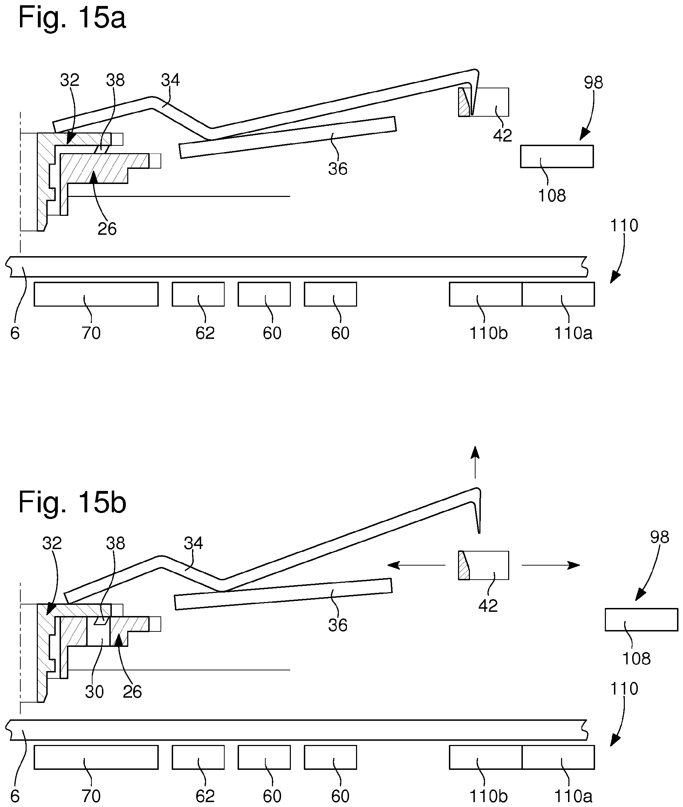

Selon un troisième mode de réalisation (voir figure 15a), le dispositif mécanique de sonnerie comprend l'organe indicateur mécanique 98 du type d'une pastille 108 qui indique l'état armé ou non-armé du dispositif mécanique de sonnerie, et le dispositif électronique 56 comprend un capteur d'images 110 du type déjà décrit dont une première fraction de la surface 110a est utilisée pour scruter l'indication fournie par l'organe indicateur mécanique 98, et dont une seconde fraction de la surface 110b est utilisée pour scruter la mise en marche du dispositif mécanique de sonnerie 20. On peut par exemple imaginer que la pastille 108 soit visible par la première fraction de surface 110a du capteur d'images 110 lorsque le dispositif mécanique de sonnerie 20 est à l'état non-armé, puis que la pastille 108 s'efface et sorte du champ de vision du capteur d'images 110 lorsque le dispositif mécanique de sonnerie 20 est armé par l'utilisateur (figure 15b). A ce moment-là, le dispositif électronique 56 note un changement dans le signal produit par le capteur d'images 110 et va donner l'ordre au capteur d'images 110 de scruter le dispositif mécanique de sonnerie 20 au moyen de la fraction de surface 110b.

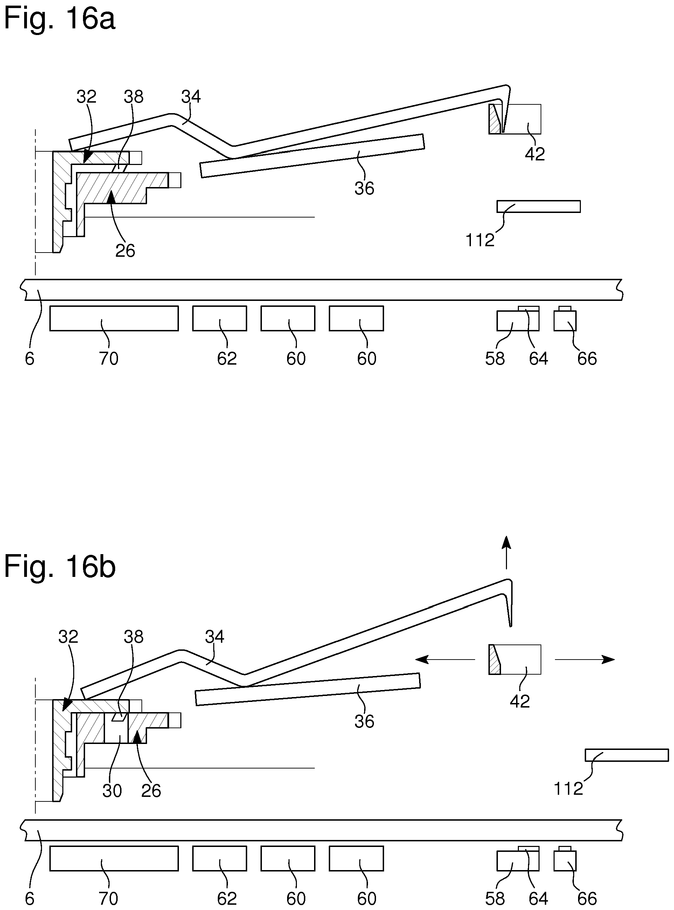

Enfin, selon un dernier mode de réalisation (figure 16a), le dispositif mécanique de sonnerie comprend un organe indicateur mécanique 112 qui masque à la vue du capteur d'images 58 le dispositif mécanique de sonnerie 20 lorsque ce dernier n'est pas armé. Lorsque l'utilisateur arme le dispositif mécanique de sonnerie 20 (figure 16b), l'organe indicateur mécanique 112 s'efface et l'unité de commande 60 observe un changement dans le signal fourni par le capteur d'images 58. En réponse à ce changement, l'unité de commande 60 commande au capteur d'images 58 de scruter le dispositif mécanique de sonnerie 20 afin de détecter la mise en marche de ce dernier.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées. On notera en particulier qu'il est envisageable de différer dans le temps, par une durée fixe ou pouvant être sélectionnée par l'utilisateur, l'activation du second signal d'alarme acoustique. Autrement dit, la production du second signal acoustique généré par le dispositif électronique sera décalée temporellement par rapport à l'émission du premier signal acoustique produit par le dispositif mécanique. On comprendra également que le dispositif électronique peut indifféremment commander l'émission d'un second signal d'alarme acoustique ou d'une vibration mécanique grâce à l'utilisation d'un mécanisme vibrant logé dans l'épaisseur du bracelet. Au moment où le dispositif mécanique commence à produire le premier signal d'alarme acoustique, le dispositif électronique va commander la mise en marche du mécanisme vibrant qui va générer des vibrations qui vont être ressenties par l'utilisateur dans son poignet. Le mécanisme vibrant est typiquement un mécanisme à excentrique qui actionne une masselotte. De même, on notera que, selon une variante simplifiée d'exécution de l'invention, il peut être envisagé de fixer par avance la durée de la seconde alarme. Une fois démarrée suite à l'activation de la première alarme, la seconde alarme s'arrêtera de façon autonome une fois ce temps écoulé. Autrement dit, la seconde alarme s'activera au moment de la mise en marche de la première alarme et s'arrêtera au bout d'un temps prédéfini, indépendant de la durée d'activation de la première alarme. On notera aussi que, dans le cas où le capteur est un microphone ou un accéléromètre, il n'est pas indispensable qu'un tel capteur soit disposé sous le fond de la boîte de montre. Par conséquent, il est envisageable que le bracelet soit formé de deux brins séparés fixés chacun par une de leurs extrémités à la boîte de montre et dans lesquels sont intégrés les composants nécessaires à la mise en oeuvre de l'invention. On notera enfin que la présente invention couvre également un procédé de génération d'un signal d'alarme acoustique dans une montre-bracelet comprenant une boîte de montre 2 dans laquelle est logé un mouvement d'horlogerie mécanique 18 comprenant un dispositif mécanique 20 de sonnerie agencé pour produire un premier signal d'alarme acoustique, la boîte de montre 2 étant associée à un bracelet 4 dans lequel est logé un dispositif électronique 56 pour produire un second signal d'alarme acoustique et/ou une vibration mécanique, le dispositif électronique 56 étant agencé pour produire le second signal d'alarme acoustique au moment où le dispositif mécanique 20 d'exécution de la première fonction mécanique produit le premier signal d'alarme acoustique ou après une durée préétablie ou sélectionnable par l'utilisateur suivant la mise en marche du dispositif mécanique 20.

### Nomenclature

Montre-bracelet 1
Boîte de montre 2
Bracelet 4
Fond 6
Glace 8
Cadran 10
Aiguilles d'heures 12, de minutes 14 et de secondes 16
Mouvement d'horlogerie mécanique 18
Dispositif mécanique de sonnerie 20
Tige de remontoir 22
Première, seconde et troisième roue de renvoi 24a, 24b et 24c
Roue de déclenchement 26
Index 28
Trois ouvertures 30
Roue des heures 32
Levier de déclenchement 34
Ressort 36
Trois ergots 38
Plan incliné 40
Ancre de sonnerie 42
Roue de sonnerie 44
Point de pivotement 46
Marteau 48
Bascule de remontoir de sonnerie 50
Bascule de verrou 52
Verrou de sonnerie 54
Dispositif électronique 56
Capteur d'images 58
Unité de commande 60
Générateur électronique de son 62
Lentille de collimation 64
Source de lumière 66
Feuille de circuit imprimé 68
Source de courant électrique 70
Ouvertures 72, 74
Capteur capacitif 76
Oscillateur RC 78
Démodulateur 80
Etage de sortie 82
Interrupteur reed 84
Lames souples 86
Aimant 88
Capteur inductif 90
Bobinage 92
Circuit magnétique 94
Microphone 96
Organe indicateur mécanique 98
Pastille 100
Première partie de surface 100a absorbante
Seconde partie de surface 100b réfléchissante
Source de lumière 102
Capteur de lumière 104
Capteur d'images 106
Pastille 108
Capteur d'images 110
Première fraction de surface 110a
Seconde fraction de surface 110b
Organe indicateur mécanique 112

## Revendications

1. Montre-bracelet comprenant une boîte de montre (2) dans laquelle est logé un mouvement d'horlogerie mécanique (18) comprenant un dispositif mécanique (20) d'exécution d'au moins une première fonction mécanique, la boîte de montre (2) étant associée à un bracelet (4) dans lequel est logé un dispositif électronique (56) agencé pour exécuter au moins une seconde fonction électronique, l'exécution de la seconde fonction électronique étant conditionnée par l'exécution de la première fonction mécanique.

2. Montre-bracelet selon la revendication 1, **caractérisée en ce que** le dispositif mécanique d'exécution de la première fonction mécanique est un dispositif mécanique de sonnerie (20) agencé pour produire un premier signal d'alarme acoustique, et le dispositif électronique (56) logé dans le bracelet (4) est agencé pour produire un second signal d'alarme acoustique et/ou une vibration mécanique, le dispositif électronique (56) étant agencé pour produire le second signal d'alarme acoustique au moment où le dispositif mécanique de sonnerie produit le premier signal d'alarme acoustique ou après une durée préétablie ou sélectionnable par l'utilisateur suivant la mise en marche du dispositif mécanique de sonnerie.

3. Montre-bracelet selon la revendication 2 comprenant un fond (6) transparent, **caractérisée en ce que** le dispositif électronique (56) d'exécution de la seconde fonction électronique comprend un capteur d'images (58) agencé dans le bracelet (4) de façon à se trouver sous le fond (6) transparent et capable de détecter la mise en mouvement d'un mobile du dispositif mécanique de sonnerie.

4. Montre-bracelet selon la revendication 3, **caractérisée en ce que** le capteur d'images (58) est agencé de façon à être capable de détecter un changement dans les niveaux de gris d'une image qu'il scrute.

5. Montre-bracelet selon la revendication 4, **caractérisée en ce que** le capteur d'images (58) est du type CMOS.

6. Montre-bracelet selon l'une des revendications 3 à 5, **caractérisée en ce que** le dispositif électronique (56) d'exécution de la seconde fonction électronique comprend une source de lumière (66) agencée dans le bracelet (4) afin d'améliorer les conditions dans lesquelles le capteur d'images (58) effectue les prises de vues.

7. Montre-bracelet selon l'une des revendications 3 à 6, **caractérisée en ce que** le capteur d'images (58) est agencé pour envoyer un signal électrique à une unité électronique de commande (60) qui est agencée pour commander la mise en marche d'un générateur électronique de son (62) ou de vibrations dès que le capteur d'images (58) constate que le dispositif mécanique de sonnerie (20) se met en marche et émet le premier signal d'alarme acoustique.

8. Montre-bracelet selon la revendication 7, **caractérisée en ce que** le capteur d'images (58) est agencé pour envoyer un signal électrique à l'unité électronique de commande (60) qui est agencée pour commander l'arrêt du générateur électronique de son (62) ou de vibrations lorsque le mobile que scrute le capteur d'images (58) s'arrête et que le premier signal d'alarme acoustique s'interrompt.

9. Montre-bracelet selon l'une des revendications 3 à 8, **caractérisée en ce que** le capteur d'images (58) est recouvert par une lentille de collimation (64).

10. Montre-bracelet selon la revendication 1 ou 2 comprenant un fond (6) opaque non conducteur de l'électricité, **caractérisée en ce que** le dispositif électronique (56) d'exécution de la seconde fonction électronique comprend un capteur capacitif (76), un capteur magnétique ou un capteur inductif (90) agencé dans le bracelet (4) de façon à se trouver sous le fond (6) opaque non conducteur de l'électricité et capable de détecter la mise en mouvement d'un mobile du dispositif mécanique (20).

11. Montre-bracelet selon la revendication 10, **caractérisée en ce que** le capteur capacitif (76) comprend un oscillateur RC (78), un démodulateur (80) et un étage de sortie (82) qui sont agencés pour envoyer un signal électrique à une unité électronique de commande (60) qui est agencée pour commander la mise en marche d'un générateur électronique de son (62) ou de vibrations dès que le capteur capacitif (76) détecte une modification de la capacité provoquée par la mise en marche du dispositif mécanique (20) d'exécution de la première fonction mécanique et l'émission d'un premier signal d'alarme acoustique par le dispositif mécanique de sonnerie (20).

12. Montre-bracelet selon la revendication 10, **caractérisée en ce que** le capteur magnétique est un interrupteur Reed (84) à lames souples (86) qui est agencé pour envoyer un signal électrique à une unité électronique de commande (60) qui est agencée pour commander la mise en marche d'un générateur électronique de son (62) ou de vibrations dès que les lames souples (86) s'attirent mutuellement et viennent en contact l'une avec l'autre sous l'effet du déplacement d'un aimant (88) qui commence à se mouvoir lorsque le dispositif mécanique (20) d'exécution de la première fonction mécanique se met en marche.

13. Montre-bracelet selon la revendication 10, **caractérisée en ce que** le capteur magnétique est un capteur à magnétorésistance géante qui est agencé pour envoyer un signal électrique à une unité électronique de commande (60) qui est agencée pour commander la mise en marche d'un générateur électronique de son (62) ou de vibrations dès que la résistance électrique du capteur varie sous l'effet du déplacement d'un aimant (88) qui commence à se mouvoir lorsque le dispositif mécanique (20) d'exécution de la première fonction mécanique se met en marche.

14. Montre-bracelet selon la revendication 10, **caractérisée en ce que** le capteur inductif (90) comprend un bobinage (92) réalisé autour d'un circuit magnétique (94) et est agencé pour envoyer un signal électrique à une unité électronique de commande (60) qui est agencée pour commander la mise en marche d'un générateur électronique de son (62) ou de vibrations dès qu'un courant électrique est induit dans le bobinage (92) sous l'effet du déplacement d'un aimant (88) qui commence à se mouvoir lorsque le dispositif mécanique (20) d'exécution de la première fonction mécanique se met en marche.

15. Montre-bracelet selon la revendication 10, **caractérisée en ce que** le capteur inductif (90) comprend un circuit oscillant LC agencé pour envoyer un signal électrique à une unité électronique de commande (60) qui est agencée pour commander la mise en marche d'un générateur électronique de son (62) ou de vibrations dès que l'inductance varie sous l'effet d'un déplacement d'un mobile métallique du dispositif mécanique (20) d'exécution de la première fonction mécanique.

16. Montre-bracelet selon la revendication 1 ou 2, **caractérisée en ce que** le dispositif électronique (56) d'exécution de la seconde fonction électronique comprend un microphone (96) agencé pour détecter une onde acoustique produite par la mise en marche du dispositif mécanique (20) d'exécution de la première fonction mécanique et pour envoyer un signal électrique à une unité électronique de commande (60) qui commande la mise en marche d'un générateur électronique de son (62) ou de vibrations.

17. Montre-bracelet selon la revendication 1 ou 2, **caractérisée en ce que** le dispositif électronique (56) d'exécution de la seconde fonction électronique comprend un accéléromètre agencé pour détecter les vibrations mécaniques engendrées par la mise en marche du dispositif mécanique (20) d'exécution de la première fonction mécanique et pour envoyer un signal électrique à une unité électronique de commande (60) qui commande la mise en marche d'un générateur électronique de son (62) ou de vibrations.

18. Montre-bracelet selon la revendication 1 ou 2, **caractérisée en ce que** le dispositif mécanique (20) d'exécution de la première fonction mécanique comprend un organe indicateur mécanique (98) qui fournit une indication sur l'état armé ou non-armé du dispositif mécanique (20) d'exécution de la première fonction mécanique, et le dispositif électronique (56) comprend des moyens agencés pour scruter l'indication fournie par l'organe indicateur mécanique (98) et des moyens qui sont agencés pour détecter l'instant auquel la première fonction mécanique va se déclencher.

19. Montre-bracelet selon la revendication 18, **caractérisée en ce que** l'organe indicateur mécanique (98) comprend une pastille (100) dont une première portion de surface (100a) est absorbante et dont une seconde portion de surface (100b) est réfléchissante, cette pastille (100) étant agencée pour se déplacer entre une première et une seconde position selon que le dispositif mécanique (20) est non-armé ou armé, et **en ce que** les moyens agencés pour scruter l'indication fournie par l'organe indicateur mécanique (98) comprennent une source de lumière (102) et un capteur de lumière (104) logés dans le bracelet (4), sous la pastille (100), la lumière émise par la source de lumière (102) étant absorbée ou réfléchie selon qu'elle tombe sur la première portion de surface (100a) absorbante ou sur la seconde portion de surface (100b) réfléchissante de la pastille (100), les moyens agencés pour détecter l'instant auquel la première fonction mécanique va se déclencher comprenant un capteur d'images (106) capable de détecter la mise en mouvement d'un mobile du dispositif mécanique (20) commençant à scruter le moment où le dispositif mécanique (20) va se mettre en marche lorsque le capteur de lumière (104) capte la lumière réfléchie par la seconde portion de surface (100b) réfléchissante de la pastille (100).

20. Montre-bracelet selon la revendication 18, **caractérisée en ce que** les moyens agencés pour scruter l'indication fournie par l'organe indicateur mécanique (98) comprennent une source de lumière (102) et un capteur de lumière (104) logés dans le bracelet (4), sous une pastille dont une première portion de surface réfléchit la lumière selon une direction dans laquelle le capteur de lumière (104) ne peut capter la lumière et dont une seconde portion de surface réfléchit la lumière en direction du capteur de lumière (104), cette pastille (100) étant agencée pour se déplacer entre une première et une seconde position selon que le dispositif mécanique (20) est non-armé ou armé, la lumière émise par la source de lumière (102) étant donc déviée ou réfléchie selon qu'elle tombe sur la première portion de surface ou sur la seconde portion de surface de la pastille, les moyens agencés pour détecter l'instant auquel la première fonction mécanique va se déclencher comprenant un capteur d'images (106) capable de détecter la mise en mouvement d'un mobile du dispositif mécanique (20) et commençant à scruter le moment où le dispositif mécanique (20) va se mettre en marche lorsque le capteur de lumière (104) capte la lumière réfléchie par la pastille.

21. Montre-bracelet selon la revendication 18, **caractérisée en ce que** le dispositif électronique (56) comprend un capteur d'images (110) dont, respectivement, une première fraction de la surface (110a) est utilisée pour scruter l'indication fournie par l'organe indicateur mécanique (98), et une seconde fraction de la surface (110b) est utilisée pour détecter la mise en marche du dispositif mécanique (20).

22. Procédé de génération d'un signal d'alarme acoustique dans une montre-bracelet comprenant une boîte de montre (2) dans laquelle est logé un mouvement d'horlogerie mécanique (18) comprenant un dispositif mécanique (20) de sonnerie agencé pour produire un premier signal d'alarme acoustique, la boîte de montre (2) étant associée à un bracelet (4) dans lequel est logé un dispositif électronique (56) pour produire un second signal d'alarme acoustique et/ou une vibration mécanique, le procédé comportant une étape de commande dudit dispositif électronique (56) pour produire le second signal d'alarme acoustique au moment où le dispositif mécanique (20) d'exécution de la première fonction mécanique produit le premier signal d'alarme acoustique ou après une durée préétablie ou sélectionnable par l'utilisateur suivant la mise en marche du dispositif mécanique (20), la production par le dispositif électronique (56) du second signal d'alarme acoustique et/ou mécanique étant conditionnée par l'exécution de la première fonction mécanique par le dispositif mécanique (20).

## Patentansprüche

1. Armbanduhr, umfassend ein Uhrengehäuse (2), in dem ein mechanisches Uhrwerk (18) aufgenommen ist, das eine mechanische Vorrichtung (20) für die Ausführung mindestens einer ersten mechanischen Funktion enthält, wobei das Uhrengehäuse (2) mit einem Armband (4) verbunden ist, in dem eine elektronische Vorrichtung (56) eingebaut ist, die dafür ausgelegt ist, mindestens eine zweite elektronische Funktion auszuführen, wobei die Ausführung der zweiten elektronischen Funktion durch die Ausführung der ersten mechanischen Funktion bedingt ist.

2. Armbanduhr nach Anspruch 1, **dadurch gekennzeichnet, dass** die mechanische Vorrichtung für die Ausführung der ersten mechanischen Funktion eine mechanische Läutwerkvorrichtung (20) ist, die dafür ausgelegt ist, ein erstes akustisches Alarmsignal zu erzeugen, und die elektronische Vorrichtung (56), die in das Armband (4) eingebaut ist, dafür ausgelegt ist, ein zweites akustisches Alarmsignal und/oder eine mechanische Vibration zu erzeugen, wobei die elektronische Vorrichtung (56) dafür ausgelegt ist, das zweite akustische Alarmsignal zu dem Zeitpunkt zu erzeugen, zu dem die mechanische Läutwerkvorrichtung das erste akustische Alarmsignal erzeugt, oder nach einer im Voraus festgelegten oder durch den Anwender auswählbaren Dauer nach dem Betreiben der mechanischen Läutwerkvorrichtung.

3. Armbanduhr nach Anspruch 2, umfassend einen lichtdurchlässigen Boden (6), **dadurch gekennzeichnet, dass** die elektronische Vorrichtung (56) für die Ausführung der zweiten elektronischen Funktion einen Bildsensor (58) umfasst, der in dem Armband (4) in einer Weise angeordnet ist, dass er sich unter dem lichtdurchlässigen Boden (6) befindet und das Inbewegungsetzen eines Drehteils der mechanischen Läutwerkvorrichtung detektieren kann.

4. Armbanduhr nach Anspruch 3, **dadurch gekennzeichnet, dass** der Bildsensor (58) dafür ausgelegt ist, eine Änderung der Graustufen eines Bildes, das er abtastet, zu detektieren.

5. Armbanduhr nach Anspruch 4, **dadurch gekennzeichnet, dass** der Bildsensor (58) vom CMOS-Typ ist.

6. Armbanduhr nach einem der Ansprüche 3 bis 5, **dadurch gekennzeichnet, dass** die elektrische Vorrichtung (56) für die Ausführung der zweiten elektronischen Funktion eine Lichtquelle (66) enthält, die in dem Armband (4) angeordnet ist, um die Bedingungen, unter denen der Bildsensor (58) Bilder aufnimmt, zu verbessern.

7. Armbanduhr nach einem der Ansprüche 3 bis 6, **dadurch gekennzeichnet, dass** der Bildsensor (58) dafür ausgelegt ist, ein elektrisches Signal an eine elektronische Steuereinheit (60) zu senden, die dafür ausgelegt ist, die Inbetriebnahme eines elektronischen Tongenerators (62) oder Vibrationsgenerators zu befehlen, sobald der Bildsensor (58) feststellt, dass sich die mechanische Läutwerkvorrichtung (20) in Betrieb setzt und das erste akustische Alarmsignal aussendet.

8. Armbanduhr nach Anspruch 7, **dadurch gekennzeichnet, dass** der Bildsensor (58) dafür ausgelegt ist, ein elektrisches Signal an die elektronische Steuereinheit (60) zu senden, die dafür ausgelegt ist, das Anhalten des elektronischen Tongenerators (62) oder Vibrationsgenerators zu befehlen, wenn das Drehteil, das der Bildsensor (58) abtastet, anhält und das erste akustische Alarmsignal unterbrochen wird.

9. Armbanduhr nach einem der Ansprüche 3 bis 8, **dadurch gekennzeichnet, dass** der Bildsensor (58) mit einer Kollimatorlinse (64) überdeckt ist.

10. Armbanduhr nach Anspruch 1 oder 2, umfassend einen Elektrizität nicht leitenden, lichtundurchlässigen Boden (6), **dadurch gekennzeichnet, dass** die elektronische Vorrichtung (56) für die Ausführung der zweiten elektronischen Funktion einen kapazitiven Sensor (76), einen magnetischen Sensor oder einen induktiven Sensor (90) umfasst, der in dem Armband (4) in einer Weise angeordnet ist, dass er sich unter dem Elektrizität nicht leitenden, lichtundurchlässigen Boden (6) befindet und fähig ist, das Inbewegungsetzen eines Drehteils der mechanischen Vorrichtung (20) zu detektieren.

11. Armbanduhr nach Anspruch 10, **dadurch gekennzeichnet, dass** der kapazitive Sensor (76) einen RC-Oszillator (78), einen Demodulator (80) und eine Ausgangsstufe (82) umfasst, die dafür ausgelegt sind, ein elektrisches Signal an eine elektronische Steuereinheit (60) zu senden, die dafür ausgelegt ist, die Inbetriebnahme eines elektronischen Tongenerators (62) oder Vibrationsgenerators zu befehlen, sobald der kapazitive Sensor (76) eine Veränderung der Kapazität detektiert, die durch die Inbetriebnahme der mechanischen Vorrichtung (20) für die Ausführung der ersten mechanischen Funktion und das Aussenden eines ersten akustischen Alarmsignals durch die mechanische Läutwerkvorrichtung (20) hervorgerufen wird.

12. Armbanduhr nach Anspruch 10, **dadurch gekennzeichnet, dass** der magnetische Sensor ein Reed-Schalter (84) mit biegsamen Zungen (86) ist, der dafür ausgelegt ist, ein elektrisches Signal an eine elektronische Steuereinheit (60) zu senden, die dafür ausgelegt ist, die Inbetriebnahme eines elektronischen Tongenerators (62) oder Vibrationsgenerators zu befehlen, sobald sich die biegsamen Zungen (86) unter der Wirkung der Verschiebung eines Magneten (88), der sich zu bewegen beginnt, wenn sich die mechanische Vorrichtung (20) für die Ausführung der ersten mechanischen Funktion in Betrieb setzt, gegenseitig anziehen und miteinander in Kontakt gelangen.

13. Armbanduhr nach Anspruch 10, **dadurch gekennzeichnet, dass** der magnetische Sensor ein Riesenmagnetowiderstandssensor ist, der dafür ausgelegt ist, ein elektrisches Signal an eine elektronische Steuereinheit (60) zu senden, die dafür ausgelegt ist, die Inbetriebnahme eines elektronischen Tongenerators (62) oder Vibrationsgenerators zu befehlen, sobald sich der elektrische Widerstand des Sensors unter der Wirkung der Verlagerung eines Magneten (88) verändert, der sich zu bewegen beginnt, wenn sich die mechanische Vorrichtung (20) für die Ausführung der ersten mechanischen Funktion in Betrieb setzt.

14. Armbanduhr nach Anspruch 10, **dadurch gekennzeichnet, dass** der induktive Sensor (90) eine Wicklung (92) umfasst, die um einen Magnetkreis (94) ausgebildet ist und dafür ausgelegt ist, ein elektrisches Signal an eine elektronische Steuereinheit (60) zu senden, die dafür ausgelegt ist, die Inbetriebnahme eines elektronischen Tongenerators (62) oder Vibrationsgenerators zu befehlen, sobald in der Wicklung (92) unter der Wirkung der Verlagerung eines Magneten (88), der sich zu bewegen beginnt, wenn sich die mechanische Vorrichtung (20) für die Ausführung der ersten mechanischen Funktion in Betrieb setzt, ein elektrischer Strom induziert wird.

15. Armbanduhr nach Anspruch 10, **dadurch gekennzeichnet, dass** der induktive Sensor (90) einen LC-Schwingkreis umfasst, der dafür ausgelegt ist, ein elektrisches Signal an eine elektronische Steuereinheit (60) zu senden, die dafür ausgelegt ist, die Inbetriebnahme eines elektronischen Tongenerators (62) oder Vibrationsgenerators zu befehlen, sobald sich die Induktivität unter der Wirkung einer Verlagerung eines metallischen Drehteils der mechanischen Vorrichtung (20) für die Ausführung der ersten mechanischen Funktion verändert.

16. Armbanduhr nach Anspruch 1 oder 2, **dadurch gekennzeichnet, dass** die elektronische Vorrichtung (56) für die Ausführung der zweiten elektronischen Funktion ein Mikrofon (96) umfasst, das dafür ausgelegt ist, eine Schallwelle zu detektieren, die durch die Inbetriebnahme der mechanischen Vorrichtung (20) für die Ausführung der ersten mechanischen Funktion erzeugt wird, und ein elektrisches Signal an eine elektronische Steuereinheit (60) zu senden, die die Inbetriebnahme eines elektronischen Tongenerators (62) oder Vibrationsgenerators befiehlt.

17. Armbanduhr nach Anspruch 1 oder 2, **dadurch gekennzeichnet, dass** die elektronische Vorrichtung (56) für die Ausführung der zweiten elektronischen Funktion einen Beschleunigungsmesser umfasst, der dafür ausgelegt ist, die mechanischen Vibrationen zu detektieren, die durch die Inbetriebnahme der mechanischen Vorrichtung (20) für die Ausführung der ersten mechanischen Funktion erzeugt werden, und um ein elektrisches Signal an eine elektronische Steuereinheit (60) zu senden, die die Inbetriebnahme eines elektronischen Tongenerators (62) oder Vibrationsgenerators befiehlt.

18. Armbanduhr nach Anspruch 1 oder 2, **dadurch gekennzeichnet, dass** die mechanische Vorrichtung (20) für die Ausführung der ersten mechanischen Funktion ein mechanisches Anzeigeorgan (98) umfasst, das eine Angabe über den gespannten oder nicht gespannten Zustand der mechanischen Vorrichtung (20) für die Ausführung der ersten mechanischen Funktion liefert, und die elektronische Vorrichtung (56) Mittel umfasst, um die von dem mechanischen Anzeigeorgan (98) gelieferte Angabe abzutasten, und Mittel umfasst, die dafür ausgelegt sind, den Zeitpunkt zu detektieren, zu dem die erste mechanische Funktion ausgelöst wird.

19. Armbanduhr nach Anspruch 18, **dadurch gekennzeichnet, dass** das mechanische Anzeigeorgan (98) ein Plättchen (100) umfasst, wovon ein erster Oberflächenabschnitt (100a) absorbierend ist und wovon ein zweiter Oberflächenabschnitt (100b) reflektierend ist, wobei dieses Plättchen (100) dafür ausgelegt ist, sich zwischen einer ersten und einer zweiten Position zu verlagern, je nachdem, ob die mechanische Vorrichtung (20) nicht gespannt oder gespannt ist, und dass die Mittel, die dafür ausgelegt sind, die von dem mechanischen Anzeigeorgan (98) gelieferte Angabe abzutasten, eine Lichtquelle (102) und einen Lichtsensor (104) umfassen, die in dem Armband (4) unter dem Plättchen (100) angeordnet sind, wobei das von der Lichtquelle (102) ausgesendete Licht absorbiert oder reflektiert wird, je nachdem, ob es auf den ersten absorbierenden Oberflächenabschnitt (100a) oder auf den zweiten reflektierenden Oberflächenabschnitt (100b) des Plättchens (100) trifft, wobei die Mittel, die dafür ausgelegt sind, den Zeitpunkt zu detektieren, zu dem die erste mechanische Funktion ausgelöst wird, einen Bildsensor (106) umfassen, der das Inbewegungsetzen eines Drehteils der mechanischen Vorrichtung (20) detektieren kann und beginnt, den Zeitpunkt abzutasten, zu dem sich die mechanische Vorrichtung (20) in Betrieb setzt, wenn der Lichtsensor (104) das von dem reflektierenden zweiten Oberflächenabschnitt (100b) des Plättchens (100) reflektierte Licht empfängt.

20. Armbanduhr nach Anspruch 18, **dadurch gekennzeichnet, dass** die Mittel, die dafür ausgelegt sind, die von dem mechanischen Anzeigeorgan (98) gelieferte Angabe abzutasten, eine Lichtquelle (102) und einen Lichtsensor (104) umfassen, die in dem Armband (4) unter einem Plättchen angeordnet sind, wovon ein erster Oberflächenabschnitt das Licht in einer Richtung reflektiert, in der der Lichtsensor (104) das Licht nicht erfassen kann, und wovon ein zweiter Oberflächenabschnitt das Licht in Richtung des Lichtsensors (104) reflektiert, wobei dieses Plättchen (100) dafür ausgelegt ist, sich zwischen einer ersten und einer zweiten Position zu verlagern, je nachdem, ob die mechanische Vorrichtung (20) nicht gespannt oder gespannt ist, wobei das von der Lichtquelle (102) ausgesendete Licht somit abgelenkt oder reflektiert wird, je nachdem, ob es auf den ersten Oberflächenabschnitt oder auf den zweiten Oberflächenabschnitt des Plättchens trifft, wobei die Mittel, die dafür ausgelegt sind, den Zeitpunkt zu detektieren, zu dem die erste mechanische Funktion ausgelöst wird, einen Bildsensor (106) umfassen, der fähig ist, das Inbewegungsetzen eines Drehteils der mechanischen Vorrichtung (20) zu detektieren und beginnt, den Zeitpunkt abzutasten, zu dem sich die mechanische Vorrichtung (20) in Betrieb setzt, wenn der Lichtsensor (104) das von dem Plättchen reflektierte Licht erfasst.

21. Armbanduhr nach Anspruch 18, **dadurch gekennzeichnet, dass** die elektronische Vorrichtung (56) einen Bildsensor (110) umfasst, wovon ein erster Oberflächenanteil (110a) verwendet wird, um die von dem mechanischen Anzeigeorgan (98) gelieferte Angabe abzutasten, und entsprechend ein zweiter Oberflächenanteil (110b) verwendet wird, um die Inbetriebnahme der mechanischen Vorrichtung (20) zu detektieren.

22. Verfahren zum Erzeugen eines akustischen Alarmsignals in einer Armbanduhr, umfassend ein Uhrengehäuse (2), in dem ein mechanisches Uhrwerk (18) aufgenommen ist, das eine mechanische Läutwerkvorrichtung (20) enthält, die dafür ausgelegt ist, ein erstes akustisches Alarmsignal zu erzeugen, wobei das Uhrengehäuse (2) mit einem Armband (4) verbunden ist, in das eine elektronische Vorrichtung (56) eingebaut ist, um ein zweites akustisches Alarmsignal und/oder eine mechanische Vibration zu erzeugen, wobei das Verfahren einen Schritt des Steuerns der elektronischen Vorrichtung (56) umfasst, um das zweite akustische Alarmsignal zu dem Zeitpunkt, zu dem die mechanische Vorrichtung (20) für die Ausführung der ersten mechanischen Funktion das erste akustische Alarmsignal erzeugt, oder nach einer im Voraus festgelegten oder vom Anwender auswählbaren Dauer nach dem Inbetriebsetzen der mechanischen Vorrichtung (20) zu erzeugen, wobei die Erzeugung des zweiten akustischen und/oder mechanischen Alarmsignals durch die elektronische Vorrichtung (56) durch die Ausführung der ersten mechanischen Funktion durch die mechanische Vorrichtung (20) bedingt ist.

## Claims

1. Wristwatch comprising a watch case (2) in which is housed a mechanical timepiece movement (18) comprising a mechanical device (20) for executing at least a first mechanical function, the watch case (2) being associated with a bracelet (4) in which is housed an electronic device (56) arranged to execute at least a second electronic function, the execution of the second electronic function being dependent on the execution of the first mechanical function.

2. Wristwatch according to claim 1, **characterized in that** the mechanical device for executing the first mechanical function is a mechanical striking device (20) arranged to produce a first acoustic alarm signal, and the electronic device (56) housed in the bracelet (4) is arranged to produce a second acoustic alarm signal and/or a mechanical vibration, the electronic device (56) being arranged to produce the second acoustic alarm signal at the moment when the mechanical striking device produces the first acoustic alarm signal or after a predefined or user-selectable duration following the start of operation of the mechanical striking device.

3. Wristwatch according to claim 2, comprising a transparent case back (6), **characterized in that** the electronic device (56) for executing the second electronic function comprises an image sensor (58) arranged in the bracelet (4) so as to be located beneath the transparent case back (6) and capable of detecting the start of motion of a movable element of the mechanical striking device.

4. Wristwatch according to claim 3, **characterized in that** the image sensor (58) is arranged to be capable of detecting a change in the levels of grey in an image scanned by the sensor.

5. Wristwatch according to claim 4, **characterized in that** the image sensor (58) is of the CMOS type.

6. Wristwatch according to any of claims 3 to 5, **characterized in that** the electronic device (56) for executing the second electronic function comprises a light source (66) arranged in the bracelet (4) in order to improve the conditions in which the image sensor (58) takes shots.

7. Wristwatch according to any of claims 3 to 6, **characterized in that** the image sensor (58) is arranged to send an electrical signal to an electronic control unit (60) which is arranged to actuate an electronic sound or vibration generator (62) as soon as the image sensor (58) detects that the mechanical striking device (20) starts to operate and emits the first acoustic alarm signal.

8. Wristwatch according to claim 7, **characterized in that** the image sensor (58) is arranged to send an electrical signal to the electronic control unit (60) which is arranged to stop the electronic sound or vibration generator (62) when the movable element scanned by the image sensor (50) stops and when the first acoustic alarm signal stops.

9. Wristwatch according to any of claims 3 or 8, **characterized in that** the image sensor (58) is covered by a collimator lens (64).

10. Wristwatch according to claim 1 or 2 comprising an opaque non-electrically conductive case back (6), **characterized in that** the electronic device (56) for executing the second electronic function comprises a capacitive sensor (76), a magnetic sensor or an inductive sensor (90) arranged in the bracelet (4) so as to be located beneath the opaque non-electrically conductive case back (6) and capable of detecting the start of motion of a movable element of the mechanical device (20).

11. Wristwatch according to claim 10, **characterized in that** the capacitive sensor (76) comprises an RC oscillator (78), a demodulator (80) and an output stage (82) which are arranged to send an electrical signal to an electronic control unit (60) which is arranged to actuate an electronic sound or vibration generator (62) as soon as the capacitive sensor (76) detects a capacitance change caused by the start of operation of the mechanical device (20) for executing the first mechanical function and the emission of a first acoustic alarm signal by the mechanical device (20).

12. Wristwatch according to claim 10, **characterized in that** the magnetic sensor is a REED switch (84) with flexible reeds (86) which is arranged to send an electrical signal to an electronic control unit (60) which is arranged to actuate an electronic sound or vibration generator (62) as soon as the flexible reeds (86) attract each other and come into contact with each other as a result of the displacement of a magnet (88) which starts to move when the mechanical device (20) for executing the first mechanical function starts to operate.

13. Wristwatch according to claim 10, **characterized in that** the magnetic sensor is a giant magnetoresistive sensor which is arranged to send an electrical signal to an electronic control unit (60) which is arranged to actuate an electronic sound or vibration generator (62) as soon as the electrical resistance of the sensor varies as a result of the displacement of a magnet (88) which starts to move when the mechanical device (20) for executing the first mechanical function starts to operate.

14. Wristwatch according to claim 10, **characterized in that** the inductive sensor (90) comprises a winding (92) made around a magnetic circuit (94) and is arranged to send an electrical signal to an electronic control unit (60) which is arranged to actuate an electronic sound or vibration generator (62) as soon as an electrical current is induced in the winding (92) as a result of the displacement of a magnet (88) which starts to move when the mechanical device (20) for executing the first mechanical function starts to operate.

15. Wristwatch according to claim 10, **characterized in that** the inductive sensor (90) comprises an LC oscillator circuit arranged to send an electrical signal to an electronic control unit (60) which is arranged to actuate an electronic sound or vibration generator (62) as soon as the inductance varies as a result of the displacement of a movable metal element of the mechanical device (20) for executing the first mechanical function.

16. Wristwatch according to claim 1 or 2, **characterized in that** the electronic device (56) for executing the second electronic function comprises a microphone (96) arranged to detect an acoustic wave produced by the start of operation of the mechanical device (20) for executing the first mechanical function and to send an electrical signal to an electronic control unit (60) which actuates an electronic sound or vibration generator (62).

17. Wristwatch according to claim 1 or 2, **characterized in that** the electronic device (56) for executing the second electronic function comprises an accelerometer arranged to detect the mechanical vibrations generated by the start of operation of the mechanical device (20) for executing a first mechanical function and to send an electrical signal to an electronic control unit (60) which actuates an electronic sound or vibration generator (62).

18. Wristwatch according to claim 1 or 2, **characterized in that** the mechanical device (20) for executing the first mechanical function comprises a mechanical indicator member (98) which provides an indication as to whether the mechanical device for executing the first mechanical function is in a set or non-set state, and the electronic device (56) comprises means arranged to scan the indication provided by the mechanical indicator member (98) and second means which are arranged to detect the moment at which the first mechanical function will start.

19. Wristwatch according to claim 18, **characterized in that** the mechanical indicator member (98) comprises a disc (100) having a first surface portion (100a) which is absorbent and a second surface portion (100b) which is reflective, said disc (100) being arranged to move between a first and a second position depending on whether the mechanical device (20) is non-set or set, and **in that** the means arranged to scan the indication provided by the mechanical indicator member (98) comprise a light source (102) and a light sensor (104) housed in the bracelet (4), beneath the disc (100), the light emitted by the light source (102) being absorbed or reflected depending on whether the light falls on the first absorbent surface portion (100a) or on the second reflective surface portion (100b) of the disc (100), the means arranged to detect the moment at which the first mechanical function is going to start, comprising an image sensor (106) capable of detecting the start of motion of a movable element of the mechanical device (20), starting to scan for the moment when the mechanical device (20) will start to operate when the light sensor (104) senses the light reflected by the second reflective surface portion (100b) of the disc (100).

20. Wristwatch according to claim 18, **characterized in that** the means arranged to scan the indication provided by the mechanical indicator member (98) comprise a light source (102) and a light sensor (104) housed in the bracelet (4), beneath a disc having a first surface portion that reflects light in the direction in which the light sensor (104) cannot sense light and a second surface portion that reflects light in the direction of the light sensor (104), said disc (100) being arranged to move between a first and a second position depending on whether the mechanical device (20) is non-set or set, the light emitted by the light source (102) being thus deviated or reflected depending on whether the light falls on the first surface portion or on the second surface portion of the disc, the means arranged to detect the moment at which the first mechanical function will start comprising an image sensor (106) capable of detecting the start of motion of a movable element of the mechanical device (20) and starting to scan for the moment when the mechanical device (20) will start to operate when the light sensor (104) senses the light reflected by the disc.

21. Wristwatch according to claim 18, **characterized in that** the electronic device (56) comprises an image sensor (110) having, respectively, a first surface portion (110a) which is used to scan the indication provided by the mechanical indicator member (98), and a second surface portion (110b) used to detect the start of operation of the mechanical device (20).

22. Method for generating an acoustic alarm signal in a wristwatch comprising a watch case (2) in which is housed a mechanical timepiece movement (18) comprising a mechanical striking device (20) arranged to produce a first acoustic alarm signal, the watch case (2) being associated with a bracelet (4) in which is housed an electronic device (56) for producing a second acoustic alarm signal and/or a mechanical vibration, the method comprising a step of actuation of said electronic device (56) to produce the second acoustic alarm signal at the moment when mechanical device (20) for executing the first mechanical function produces the first acoustic alarm signal or after a predefined or user-selectable duration following the start of operation of the mechanical device (20), the generation by the electronic device (56) of the second acoustic and/or mechanical alarm signal being determined by the execution of the first mechanical by the mechanical device (20).
